## Europäisches Patentamt
## European Patent Office
## Office européen des brevets

(19)

(11) Numéro de publication: **0 144 752**
**B1**

(12)

# FASCICULE DE BREVET EUROPEEN

(45) Date de publication du fascicule du brevet:
**22.03.89**

(51) Int. Cl.⁴: **H 01 L 21/288, H 05 K 13/00**

(21) Numéro de dépôt: **84113282.2**

(22) Date de dépôt: **05.11.84**

(54) Dispositif pour le dépôt électrolytique d'un matériau conducteur sur des plaques de circuits intégrés.

(30) Priorité: **01.12.83 CH 6430/83**
**23.12.83 FR 8320813**

(43) Date de publication de la demande:
**19.06.85 Bulletin 85/25**

(45) Mention de la délivrance du brevet:
**22.03.89 Bulletin 89/12**

(84) Etats contractants désignés:
**DE GB NL SE**

(56) Documents cités:
**DE-A- 1 255 433**
**DE-A- 2 340 423**
**US-A- 3 306 602**
**US-A- 3 347 771**

**SOLID-STATE ELECTRONICS, vol. 16, no. 11, novembre
1973, pages 1289-1295, Pergamon Press, Oxford, GB;
O.G. LORIMOR et al.: "High capacity liquid phase
epitaxy apparatus utilizing thin melts"**

(73) Titulaire: **EM Microelectronic-Marin SA, CH-2074 Marin
(CH)**

(72) Inventeur: **Jeannot, Michel, Champréveyres 2,
CH-2000 Neuchâtel (CH)**
Inventeur: **Salvalai, Italo, Rue de Neuchâtel,
CH-2034 Peseux (CH)**

(74) Mandataire: **Barbeaux, Bernard et al, ICB Ingénieurs
Conseils en Brevets SA Passage Max. Meuron 6,
CH-2001 Neuchâtel (CH)**

## Description

L'invention concerne la fabrication des circuits intégrés et elle a pour objet un dispositif destiné à être utilisé au moment où l'on procède au dépôt par voie galvanique d'un matériau conducteur sur des plaques de circuits et en particulier lorsqu'il s'agit de former pour chaque circuit intégré sur une plaque les plots de connexion sur lesquels seront ensuite soudés, par exemple par thermocompression, des fils minces servant à relier électriquement le circuit avec l'extérieur.

La réalisation des circuits intégrés se fait souvent de la manière suivante:

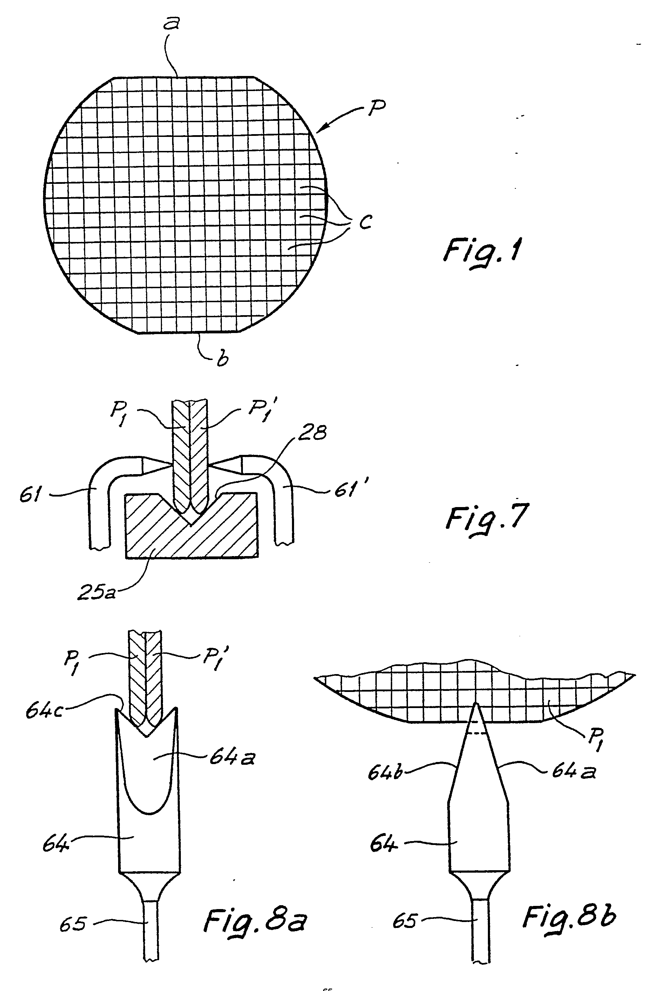

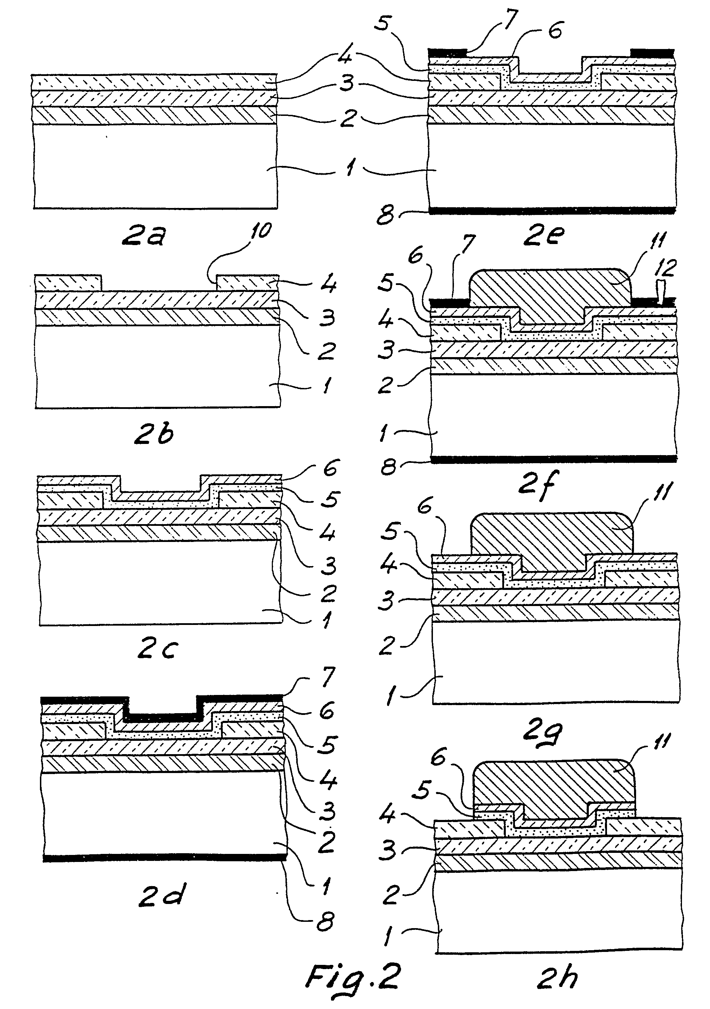

On part d'un bloc de silicium monocristallin très pur que l'on débite en tranches fines pour obtenir des plaques en forme de disques telles que celle, P, qui est représentée sur la figure 1 et dont les dimensions sont prévues pour que chacune d'elles puisse regrouper au moins plusieurs centaines de circuits élémentaires qui sont symbolisés sur la figure par des petits carrés C. La circonférence de ces disques qui sont fréquemment désignés par le nom américain «wafers», n'est généralement pas tout à fait ronde et présente deux parties droites diamétralement opposées et de longueurs inégales, qui sont désignées par les repères a et b sur la figure 1 mais qui, dans la réalité, ne sont en fait pas aussi prononcées que sur le dessin.

Le plus souvent les plaques sont, en premier lieu, soumises à un traitement qui permet de former à leur surface, celle sur laquelle les circuits doivent être intégrés, une couche d'oxyde de silicium ($SiO_2$) de protection.

Le nombre, la nature et l'ordre de succession des opérations qui viennent ensuite dépendent naturellement de la technologie d'intégration utilisée et de la nature des éléments qui composent chaque circuit à intégrer. Il s'agit principalement d'opérations de dopage et de dépôts localisés de couches conductrices, semi-conductrices ou isolantes. La plupart de ces opérations sont précédées chacune d'une phase au cours de laquelle on délimite les zones à traiter en utilisant la technique bien connue de la photogravure.

Une fois que ces différentes étapes ont été franchies on passe à la réalisation des métallisations qui servent à relier différents éléments de chaque circuit entre eux et/ou aux emplacements prévus pour les plots de connexion, mais aussi souvent à terminer la fabrication de certains composants, par exemple à former la grille d'un transistor ou la seconde armature d'un condensateur. Dans certains cas on prévoit plusieurs réseaux d'interconnexion superposés qui sont séparés par des couches isolantes.

Les circuits proprement dits étant alors terminés on recouvre ceux-ci d'une couche isolante de protection, par exemple d'une couche de verre.

On procède ensuite à la formation des plots de connexion mentionnés précédemment, qui sont plus connus en langage de métier sous leur nom anglais de «bumps», puis on sépare les circuits les uns des autres en cassant la plaque de silicium, souvent après l'avoir préalablement amincie.

Il ne reste plus après qu'à fixer les puces sur des supports, à relier par des fils minces, par exemple en or, les plots de connexion à des pattes de connexion et enfin à encapsuler chaque circuit dans un boîtier étanche ou à l'enrober de plastique en laissant sortir les pattes.

Naturellement la plupart des opérations qui ont lieu après le recouvrement des circuits par une couche de protection, sont suivies d'une inspection ou d'un essai (inspections optiques, essais électriques avant et après la mise en boîtier du circuit, essai d'herméticité du boîtier, etc.).

Les figures 2a à 2h illustrent, à titre d'exemple, un procédé qui est actuellement utilisé pour former des plots de connexion en or sur des circuits préalablement intégrés sur une plaque de silicium, lorsque les métallisations ont été réalisées en aluminium. Les rapports entre les épaisseurs des différentes couches représentées sur ces figures ne correspondent évidemment pas à la réalité.

La coupe de la figure 2a représente la plaque de circuits intégrés dans une zone où doit être réalisé un plot de connexion. A cet endroit le substrat 1 est recouvert d'au moins une couche 2 de silice ($SiO_2$), d'une métallisation en aluminium 3 et d'une couche de protection 4, par exemple en verre.

Comme le montre la figure 2b la première étape du procédé consiste à ouvrir dans la couche de protection 4 une fenêtre 10 généralement de forme carrée ou rectangulaire, à chaque endroit où doit être formé un plot de connexion. Ceci se fait en utilisant à nouveau la technique de la photogravure.

On dépose ensuite par évaporation sous vide une couche de titane-tungstène 5 puis une couche d'or 6, ceci sur toute la surface de la plaque (voir figure 2c). Ces couches métalliques intermédiaires sont prévues pour éviter que l'or qui sera déposé ensuite par voie galvanique diffuse à l'intérieur de l'aluminium formant les métallisations. Cette phase pourrait ne pas être nécessaire si les métallisations étaient elles-mêmes en or.

Lorsque le dépôt des couches intermédiaires 5 et 6 a été effectué on recouvre les faces avant et arrière de la plaque d'une couche de résine photosensible 7, resp. 8 (voir figure 2d). Comme la couche 8 sur la face arrière a seulement pour rôle d'éviter que de l'or se dépose sur cette face lorsque la plaque sera placée ultérieurement dans le bain galvanique cette couche peut très bien être constituée d'une autre matière isolante, par exemple d'une laque, que les produits constituant le bain ne peuvent pas corroder.

On expose ensuite la face avant de la plaque à la lumière, à travers un masque, et on procède à l'opération de développement qui permet d'ouvrir des fenêtres dans la couche de résine 7 et de mettre à nu la couche d'or 6. Comme le montre la figure 2e ces fenêtres sont centrées sur celles, 10, qui ont été ouvertes dans la couche de protection 4 et sont sensiblement plus grandes.

Après avoir effectué, par une méthode adéquate, un nettoyage soigneux de la plaque pour faire disparaître toute trace de résine sur la couche d'or 6, aux endroits où celle-ci a été mise à nu, on procède à la réalisation proprement dite des plots de connexion.

Pour cela on commence généralement par placer plusieurs plaques côte à côte sur un ou plusieurs supports que l'on plonge ensuite dans une cuve électrolytique contenant une solution d'un ou plusieurs sels d'or avec éventuellement un ou plusieurs additifs et dans laquelle se trouve au moins une anode.

La liaison électrique qui permet de porter la pellicule d'or 6 et les couches conductrices sous-jacentes 3, 5 de chaque plaque à un potentiel négatif et de faire jouer à ces couches le rôle de cathode pendant que les plaques sont immergées dans le bain se fait au moyen d'une ou plusieurs, par exemple trois, pointes de contact qui traversent la couche de résine photosensible 7 à des endroits où celle-ci subsiste et qui sont reliées à la borne négative de la source de tension d'alimentation qui sert à alimenter la cuve. La figure 2f montre l'une de ces pointes de contact désignée par le repère 12. Naturellement pour ne pas risquer d'endommager les circuits, les pointes sont disposées à la périphérie des plaques et ne se trouvent pas nécessairement à proximité d'endroits où doivent être formés des plots.

Dans certains cas les pointes de contact sont solidaires du support des plaques et elles sont mises en place manuellement avant que les plaques soient immergées dans le bain, mais il arrive aussi que ces pointes ne soient pas liées au support. Dans certaines machines par exemple, celles-ci sont fixées à un couvercle et elles ne se mettent en position que lorsqu'on abaisse ce couvercle.

Lorsque les plaques sont restées suffisamment longtemps dans la cuve pour que les plots de connexion aient atteint l'épaisseur voulue, celles-ci sont sorties de la cuve et séchées.

Il reste ensuite à enlever la couche de résine restante 7 sur la face avant des plaques et la couche de protection 8 sur la face arrière (voir fig. 2g), à faire disparaître également les couches d'or 6 et de titane-tungstène 5 ailleurs qu'aux emplacements des plots de connexion 11 (voir fig. 2h), à inspecter les plaques, à soumettre ces dernières à un traitement thermique pour assurer une bonne liaison cristalline entre les différentes couches métalliques 3, 5, 6 et 11 et enfin à effectuer un test électrique.

Ce procédé de formation de plots de connexion a été choisi comme exemple pour une raison qui apparaîtra par la suite, mais il est clair qu'il en existe d'autres plus ou moins différents selon la technologie utilisée pour réaliser les circuits intégrés. Par exemple le processus ne serait déjà plus le même que celui qui a été décrit si, toutes choses égales par ailleurs, les métallisations 3 étaient non pas en aluminium mais en or et/ou si les plots de connexion étaient réalisés en un autre métal, par exemple en cuivre.

D'après le US-A-3 347 771 on connaît un dispositif selon le préambule de la revendication 1. Cependant dans ce dispositif, le système mécanique et le système électrique forment un seul système qui assure en même temps le support des plaques et la liaison électrique de celles-ci avec une source de tension.

Les machines dont on dispose actuellement pour traiter galvaniquement les plaques de circuits intégrés se présentent sous différentes formes plus ou moins compliquées mais toutes présentent un inconvénient majeur, celui de ne permettre de traiter qu'un petit nombre de plaques à la fois. Par exemple il existe actuellement sur le marché des appareils sophistiqués et coûteux qui n'acceptent que vingt quatre plaques à la fois.

De ce fait la formation des plots de connexion est souvent la cause d'un ralentissement dans la production des circuits intégrés sauf si l'on accepte d'investir beaucoup pour posséder un nombre suffisamment important de machines qui occupent beaucoup de place.

La présente invention a pour but, sinon d'éviter, tout au moins de minimiser cet inconvénient en multipliant le nombre de plaques qui peuvent être traitées en même temps dans une même machine.

D'autre part, la faible cadence de production au stade de la formation des plots de connexion tient aussi au fait que celle-ci nécessite, comme on l'a vu, un nombre important d'opérations.

Un autre but de l'invention est de permettre, lorsque cela est possible, de supprimer une ou plusieurs de ces opérations.

Ces buts sont atteints grâce au dispositif revendiqué qui est en fait un support de plaques particulier destiné à être placé dans une cuve électrolytique qui peut déjà exister et qui comporte les moyens nécessaires, notamment les pointes de contact, pour relier la couche conductrice des plaques sur laquelle doit être effectué le dépôt d'une autre couche conductrice à la source d'alimentation de la cuve.

Une forme d'exécution particulièrement avantageuse de ce dispositif va maintenant être décrite en détail et à titre d'exemple, en référence aux dessins annexés sur lesquels:

– la figure 1 est une vue schématique de face d'une plaque de circuits intégrés;

– les figures 2a à 2h sont des vues en coupe d'une plaque de circuits intégrés illustrant l'exemple de procédé de formation de plots de connexion qui a été décrit ci-dessus;

– la figure 3 est une vue de face du mode de réalisation du dispositif selon l'invention choisi comme exemple;

– la figure 4 est une vue en coupe agrandie suivant le plan IV–IV de la figure 3;

– les figures 5 et 6 sont des vues en coupe agrandies respectivement selon les plans V–V et VI–VI de la figure 4;

– la figure 7 est une vue en coupe agrandie selon le plan VII–VII de la figure 3 montrant une forme possible de réalisation des pointes de contact;

– les figures 8a et 8b sont des vues respectivement de face et de côté d'une autre forme d'exécution des pointes de contact; et

– la figure 9 montre schématiquement comment, sous la forme d'exécution choisie comme exemple, plusieurs dispositifs selon l'invention peuvent être placés dans une cuve électrolytique.

Sous la forme de réalisation qui va maintenant être décrite en détail et qui est représentée, vue de face, sur la figure 3, le dispositif selon l'invention est prévu pour permettre d'effectuer un dépôt galvanique sur huit plaques de circuits intégrés à la fois et pour être placé verticalement dans la cuve électrolytique qui est utilisée pour faire ce dépôt.

Ce dispositif comprend un chassis rigide de forme rectangulaire 20 formé de deux montants verticaux 21, 22 et de quatre traverses horizontales 23, 24, 25, 26 qui, comme d'autres éléments qui seront décrits par la suite, sont assemblés de préférence au moyen de vis non représentés afin de faciliter le montage et le démontage du dispositif et éventuellement le changement de pièces défectueuses. Naturellement d'autres moyens d'assemblage, par exemple de la colle, pourraient être employés.

Toutes les parties du chassis 20, y compris les vis, sont constituées en un matériau électriquement isolant, par exemple en une matière plastique dure, qui n'est pas susceptible d'être corrodé par le bain galvanique dans lequel le dispositif doit être plongé en presque totalité. Bien entendu le matériau utilisé n'est pas forcément le même pour tous les éléments. Par exemple celui qui compose les vis est généralement différent de celui dont sont formés les montants et les traverses.

Par ailleurs, à la différence des traverses 23, 24 et 26 qui, comme les montants 21, 22, sont constituées par de simples barres de section carrée ou rectangulaire, la traverse 25, qui est située sensiblement à mi-distance entre les traverses 24 et 26, est en deux parties. Elle se compose d'une première barre 25a dont la longueur est inférieure à la distance entre les deux montants et qui repose indirectement sur une seconde barre 25b qui est, elle, fixée aux montants du chassis. Entre les deux barres 25a et 25b se trouve une autre barre 58 plus mince qui, contrairement aux éléments du chassis 20, est métallique et recouverte d'une couche de matière électriquement isolante, par exemple d'une couche de matière plastique ou d'une peinture. Cette barre 58 fait partie du système électrique qui permet, lorsque les plaques sont mises en place sur le dispositif, de relier les couches conductrices des circuits intégrés sur lesquels le dépôt doit être effectué à la source de tension d'alimentation de la cuve et qui sera décrit en détail par la suite. Les deux parties de la traverse 25 et la barre métallique 58 sont elles aussi assemblées de préférence au moyen de vis en matière plastique non représentées sur la figure.

Cette disposition permet d'assurer la fixation du système électrique, qui est en une seule pièce, sur le chassis et elle a notamment pour avantages de faciliter la fabrication et la mise en place du système électrique, de permettre de changer ce dernier sans problèmes lorsque cela s'avère nécessaire et de donner à l'ensemble une bonne rigidité. Toutefois, il est bien clair qu'il existe d'autres possibilités mais moins avantageuses. On pourrait envisager par exemple de réaliser la traverse 25 sous la forme d'une seule barre et prévoir des bandes conductrices ou des fils sur les côtés de celle-ci.

La traverse 23 située à l'extrémité supérieure des montants et dont le bord inférieur est muni d'une encoche centrale 27 ne joue aucun rôle vis à vis des plaques. Elle est seulement prévue pour permettre de suspendre le dispositif dans la cuve dans le cas par exemple où celle-ci est surmontée d'une barre horizontale, et elle pourrait très bien être remplacée suivant les cas, soit par un ou plusieurs crochets fixés à l'extrémité des montants ou sur la traverse 24, soit par des bras latéraux qui viendraient prendre appui sur les bords de la cuve ou sur des supports prévus à cet effet, ou même encore par d'autres moyens de suspension.

Pour faciliter la suite de la description et vu que la traverse 23 dont il vient d'être question n'est pas une pièce indispensable du dispositif, on qualifiera les trois autres traverses 24, 25, 26 respectivement de «supérieure», «centrale» et «inférieure».

Par ailleurs, afin de mieux montrer, d'une part, les dimensions qu'ont les différentes parties du dispositif par rapport à celles des plaques et, d'autre part, la façon d'agir des moyens de positionnement et de maintien de ces dernières sur le chassis qui seront décrits plus loin, on a représenté sur la figure 3 qui est sensiblement à l'échelle le dispositif avec les plaques en place. Naturellement, comme celles-ci sont réunies par paires, les deux plaques d'une même paire étant accolées dos à dos, et comme le dispositif est conçu pour recevoir les quatre paires de plaques dans le plan du chassis 20, seules quatre de ces plaques, désignées par les repères $P_1$, $P_2$, $P_3$, $P_4$, sont visibles sur la figure.

On voit que, d'une part, la traverse supérieure 24 et la première partie 25a de la traverse centrale 25 et, d'autre part, la seconde partie 25b de la traverse centrale et la traverse inférieure 26 définissent avec les deux montants 21, 22 deux espaces rectangulaires $E_1$, $E_2$ de même hauteur et naturellement de même largeur, destinés à recevoir chacun deux paires de plaques l'une à côté de l'autre. La hauteur de ces espaces est un peu plus grande que le diamètre des plaques pour laisser la place à une partie des moyens de positionnement et de maintien en place de ces dernières, tandis que leur largeur est un peu supérieure au double de ce diamètre notamment pour faciliter la mise en place des plaques sur le dispositif. Par exemple, pour un diamètre de plaques d'environ 10 cm, une hauteur de 11,5 cm ou 12 cm et une largeur de 24 ou 25 cm conviennent très bien.

Le système de positionnement et de maintien qui est prévu pour des plaques placées dans l'es-

pace supérieur $E_1$ est tout à fait identique à celui qui est prévu pour les plaques disposées dans l'espace $E_2$. Les deux systèmes sont simplement symétriques par rapport au plan médian I–I de la traverse centrale 25. On n'en décrira par conséquent qu'un seul, celui du haut. Pour cela on ne se référera pas seulement à la figure 3 mais aussi aux figures 4 à 7.

Le système se compose principalement d'une rainure longitudinale en V, 28, que présente la face supérieure de la première barre 25a de la traverse centrale et d'un mécanisme 29 situé dans la partie supérieure de l'espace $E_1$, et qui a notamment pour rôle d'exercer sur chaque plaque une force verticale tendant à pousser celle-ci vers le bas. La rainure en V 28 de la barre 25 est destinée à recevoir les bords des plaques dans l'une des deux parties a, b où ceux-ci sont droits (voir fig. 1), de préférence dans la partie a qui est la plus longue. Comme le montre la vue en coupe agrandie de la figure 7, les plaques ont un bord arrondi, ce qui fait que si l'on donne à l'angle d'ouverture du V de la rainure une valeur convenable, si l'on introduit les bords de deux plaques $P_1$, $P'_1$ placées exactement dos à dos dans la rainure de façon que ces bords soient chacun en contact avec un flanc de cette rainure et que les plaques soient sensiblement verticales et enfin si l'on applique en permanence une force également verticale sur ces dernières, les flancs de la rainure exerceront sur les bords des plaques deux forces opposées qui auront tendance tout d'abord à amener celle-ci en contact l'une avec l'autre si elles ne le sont pas déjà et ensuite à les maintenir parfaitement accolées.

On va décrire maintenant le mécanisme 29 qui permet justement d'appliquer cette force verticale de haut en bas sur les plaques lorsqu'elles sont en place et qui comporte, lui aussi, pour chaque paire de plaques, une rainure en V qui agit de la même manière sur les bords des plaques que celle de la barre 25a mais dans leur partie diamètralement opposée.

En considérant toujours la figure 3 et également la vue en coupe agrandie de la figure 4, on voit que le mécanisme 29 est symétrique par rapport au plan médian vertical II–II du chassis et qu'il comprend, de chaque côté de ce plan, un couple de petits leviers 30, 31, resp. 32, 33, de même longueur et de section carrée ou rectangulaire qui sont placés côte à côte dans la direction perpendiculaire au plan du chassis, c'est-à-dire à celui de la figure 3, et qui sont à une faible distance l'un de l'autre, par exemple environ 1 mm, sauf à chaque bout ou ils sont accolés. Ces leviers sont fixés par l'une de leurs extrémités 30a, 31a, resp. 32a, 33a au montant correspondant du chassis 20, de façon à pouvoir pivoter ensemble et séparément, au moins d'un petit angle, autour d'un même axe 34, resp. 35, lié au montant et perpendiculaire au plan du chassis. Cette fixation peut être réalisée par exemple au moyen d'une vis 36, resp. 37, traversant le montant et les extrémités des leviers et dont l'axe constitue l'axe de pivotement de ces derniers.

Comme le montre la figure 4, chaque levier n'a pas forcément une section constante et celle-ci n'est pas nécessairement la même pour les deux leviers d'un même couple. La forme de ces leviers est en fait conditionnée par la façon dont est conçu le dispositif dans le détail.

Les deux leviers de chaque couple présentent sur leur face en regard de la traverse centrale 25 et à égale distance du montant du chassis, un bossage plat et allongé 43, resp. 44, ou 45, resp. 46, dont la longueur est à peu près égale à celle de l'une ou l'autre des parties droites a, b (voir fig. 1) des bords des plaques de circuits intégrés, et dont le milieu est situé à une distance du montant du chassis qui est supérieure au rayon de ces plaques. Par ailleurs, comme le montre la figure 5, le bossage de chacun des leviers a, du côté de l'autre levier, son bord chanfreiné de façon à former la rainure en V dont il a déjà été question précédemment, cette rainure, 47, se trouvant en face de celle de la barre 25a de la traverse centrale 25 et ayant sensiblement la même ouverture.

A noter que les bossages 43 et 44 sont surtout prévus pour faciliter la mise en place, l'enlèvement et, éventuellement le positionnement correct des plaques sur le chassis et qu'ils ne sont pas indispensables. Une rainure en V formée sur toute la longueur d'une fente séparant les deux leviers sans bossages ou seulement sur une partie de celle-ci conviendrait également.

Les deux couples de leviers sont réunis par une pièce centrale de raccordement 38 en forme de H entre les branches 38a, 38b, 38c, 38d, de laquelle sont engagées et maintenues d'une manière qui sera décrite par la suite, les extrémités 30b, 31b, 32b et 33b des leviers. Cette pièce 38 comporte en son centre un trou dans lequel passe une vis 39 partiellement filetée et dont la pointe est vissée dans la traverse supérieure 24 du chassis, de façon à permettre un léger déplacement vertical de la pièce centrale 38 entre une position basse où elle prend appui sur la tête de la vis 39 et une position haute pour laquelle elle est en contact avec la traverse supérieure.

La liaison entre chaque couple de leviers 30, 31, resp. 32, 33, et la pièce centrale 38 est réalisée au moyen d'un axe 40, resp. 41, qui passe dans des trous formés dans les branches 38a, 38b, resp. 38c, 38d, du H et dans les extrémités 30b, 31b, resp. 32b, 33b des leviers.

Comme le montre la vue en coupe agrandie de la figure 6, pour que l'on puisse déplacer verticalement la pièce de raccordement 38 et faire pivoter les leviers autour des axes 34, 35 qui sont solidaires des montants du chassis, les trous 42 formés dans les extrémités de ces leviers et dans lesquels passent les axes 40, 41 sont des trous de forme oblongue dont la longueur est dans la direction de celle des leviers et légèrement supérieure au diamètre de ces axes 40, 41. La figure 6 montre également que les trous 42 sont prévus pour qu'il y ait un certain jeu entre leurs bords et les axes 40, 41 dans le sens de la largeur. Ce jeu qui est moins important que celui qui existe dans le sens de la longueur des trous est prévu pour que les deux leviers d'un même couple puissent avoir l'un par rapport à l'autre un mouvement de cisaillement de très faible amplitude mais suffisant pour compenser les différences de diamètre que peuvent présenter les plaques de circuits intégrés et qui peuvent atteindre facilement 5/10 mm. ou même plus.

A noter que c'est en fait à cause de cette différence de diamètre que peut présenter une plaque par rapport à une autre que, dans le mode de réalisation du dispositif selon l'invention qui est actuellement décrit, on prévoit quatre leviers. Evidemment on pourrait aussi très bien concevoir un dispositif moins perfectionné qui ne comprendrait qu'un levier par paire de plaques ou faire appel à une autre solution, par exemple ne prévoir qu'un levier par paire de plaques et recouvrir les flancs de la rainure en V de ce levier et/ou de la traverse centrale 25 d'une fine couche de matière isolante élastique.

Pour en revenir à la forme de réalisation choisie comme exemple, il reste à dire, d'une part, que le mécanisme 29 comprend également quatre lames de ressort 48, 49, 50, 51 en matériau isolant élastique ou en métal recouvert d'une couche isolante qui sont fixées au moins par l'une de leurs extrémités sur la face inférieure de la traverse supérieure 24, par exemple à l'aide de vis non représentées, et qui agissent chacune sur l'un des leviers 30–33 de façon à exercer sur celui-ci la force verticale nécessaire pour maintenir les paires de plaques en place et les deux plaques d'une même paire accolées l'une contre l'autre et, d'autre part, que les dimensions des différentes parties qui composent ce mécanisme 29 et la position des axes de pivotement 34, 35 sur les montants 21, 22 du chassis 20 sont telles que, en présence des plaques de circuits intégrés, les leviers 30–33 soient pratiquement parallèles aux traverses du chassis, la pièce de raccordement 38 se trouvant alors en butée contre la tête de la vis 39.

Comme cela a déjà été dit, le système de positionnement et de maintien des plaques dans l'espace inférieur $E_2$ du chassis est tout à fait identique à celui qui vient d'être décrit. Comme la barre supérieure 25a de la traverse centrale 25, la barre inférieure 25b comporte une rainure longitudinale 52 et on trouve dans la partie inférieure de l'espace $E_2$ le même système de leviers, les ressorts et la vis centrale de ce système 53 étant cette fois fixés à la traverse inférieure 26 du chassis. Chaque système de positionnement et de maintien des plaques peut par ailleurs comporter deux butées 54, 55, resp. 56, 57, fixées chacune sur un montant 21, 22 du chassis, à mi-distance entre la traverse 25 centrale et le mécanisme de leviers 29, resp. 53, et qui peuvent elles aussi présenter des rainures en V sur leurs faces opposées à celles qui touchent les montants. Ces butées 54–57 ont pour rôle de faciliter le positionnement des paires de plaques de façon que les parties droites a ou b des bords de celle-ci se trouvent bien dans les rainures en V 47, formées au niveau des bossages 43–46 que présentent les leviers et en face desquels se trouvent les pointes de contact qui font partie du système électrique dont il va maintenant être question.

Ce système électrique qui, comme cela a déjà été indiqué précédemment, est en une seule pièce et supporté par le chassis, comprend, en plus de la barre 58 qui est prise entre les deux parties 25a, 25b de la traverse centrale, une tige métallique droite 59 dont un bout est soudé à une extrémité de la barre 58 et qui suit l'un, 22, des montants, du chassis et se prolonge au-delà de la traverse de suspension 23. Cette tige porte à son extrémité libre une tête non représentée sur la figure 3, qui est prévue par exemple pour recevoir une fiche ou pour être prise dans une pince type crocodile, cette fiche ou cette pince étant reliée électriquement à la borne négative de la source d'alimentation de la cuve.

Le système électrique comprend également huit fils conducteurs rigides, c'est-à-dire un par plaque de circuits intégrés.

Quatre de ces fils 60, 61, 62, 63, sont soudés sur l'un des côtés de la barre métallique 58 et les quatre autres 60' à 63' qui ne sont pas visibles sur la figure 3 sur l'autre côté.

Comme le montre la figure 7, chacun de ces fils se termine par une pointe et est coudé de façon que la pointe soit perpendiculaire à la face avant de la plaque correspondante et vienne prendre appui élastiquement contre cette face.

Enfin il faut préciser qu'à l'exception de la tête au bout de la tige 59 et des extrémités des pointes de contact, tout le système électrique est recouvert par une couche de protection en matériau électriquement isolant, par exemple par une peinture plastique.

Il existe différentes façons de procéder pour mettre les plaques en place sur le dispositif qui sont évidentes. La plus simple consiste, par exemple pour les plaques $P_1$ et $P'_1$, tout d'abord à mettre ces dernières dos à dos en veillant à ce que les parties droites a, b (voir figure 1) de leurs bords coïncident à peu près, à introduire verticalement par exemple les parties droites a les plus longues dans la rainure en V de la barre 25a, ceci en écartant légèrement les pointes de contact 61, 61', à soulever la pièce de raccordement 38, à amener les bords supérieurs des plaques en face de la rainure en V formée par les leviers 32 et 33 et à laisser redescendre la pièce de raccordement. Il ne reste plus ensuite qu'à faire glisser légèrement la paire de plaques pour l'amener contre la butée latérale 55 et à appuyer sur les pointes de contact 61, 61' pour les faire traverser la couche de résine photosensible qui recouvre les plaques et les amener au contact de la couche conductrice sur laquelle les plots de connexion doivent être formés.

Il faut remarquer que le dispositif qui vient d'être décrit peut être considéré comme un module qui pourrait être associé à un ou plusieurs autres pour former un ensemble permettant de traiter un nombre beaucoup plus important de plaques à la fois. Il est clair que, dans ce cas, certaines pièces comme des montants ou des traverses du chassis pourraient être communes à deux ou plusieurs modules.

Il est également important de souligner que le dispositif selon l'invention permet de placer en même temps dans une cuve électrolytique deux vois plus de plaques que si celle-ci étaient disposées simplement côte à côte comme c'est le cas pour des systèmes comparables qui existent actuellement. Il permet également, lorsqu'il s'agit de former des plots de connexion pour des circuits intégrés réalisés sur une plaque en matériau semi-conducteur, en faisant appel par exemple au procédé décrit précédemment en rapport avec les figures 2a à 2h, de ne pas avoir à recouvrir la face arrière des plaques d'une couche de résine photosensible ou d'une autre matière isolante pour éviter un dépôt de métal sur cette face, ni à avoir à enlever ensuite cette couche protectrice.

La suppression de ces deux opérations qui est possible grâce au fait que les plaques sont placées dos à dos sur le dispositif et maintenues accolées l'une contre l'autre, représente non seulement une économie de temps mais également une économie de matière.

Si l'on ajoute à cela le fait que la mise en place des plaques est plus facile et plus rapide que dans le cas des dispositifs connus et notamment ceux où les pointes de contact ne sont pas solidaires du support des plaques et où ces dernières doivent être positionnées avec une grande précision, on voit que le dispositif selon l'invention permet bien d'atteindre les principaux buts visés, c'est-à-dire d'augmenter la cadence de production et de réaliser une économie au stade de la réalisation des plots de connexion, dans la chaîne de fabrication des circuits intégrés.

En fait la productivité relativement faible au niveau de la réalisation des plots de connexion et l'importance de la participation de cette réalisation au prix de revient des circuits intégrés ne sont pas seulement dues au fait qu'actuellement celle-ci nécessite des opérations et des manipulations nombreuses et assez longues et que peu de plaques peuvent être traitées à la fois dans un seul appareil, mais aussi à ce qu'il y a un pourcentage assez important de déchet, et ceci en particulier pour les raisons suivantes:

Tout d'abord il est toujours possible que, pendant la croissance des plots de connexion, des bulles d'hydrogène viennent s'accrocher sur ceux-ci. Il est donc nécessaire de temps en temps de remuer les supports des plaques ou d'agiter le bain et il arrive que, pour cette raison, la liaison électrique entre les pointes de contact et la couche conductrice sur laquelle sont formés les plots soit rompue.

L'autre raison est qu'il arrive très souvent que le métal, par exemple l'or, qui forme les plots de connexion se dépose également autour des pointes de contact et forme des surépaisseurs qui, dans les cas où l'on procède à un amincissement des plaques de circuits intégrés après la formation des plots, sont parfois la cause de la rupture de celles-ci.

Grâce à sa conception, le dispositif selon l'invention permet également de supprimer ces inconvénients que présentent les appareils existants mais à la condition que la couche conductrice sur laquelle sont formés les plots de connexion ou une couche en contact électrique avec celle-ci existe également volontairement ou non sur au moins une partie du bord des plaques, ce qui peut être le cas pour la couche d'or 6 de la figure 2 et pour la partie droite la plus longue a des plaques lorsque l'on procède d'une certaine manière au dépôt de cette couche par évaporation sous vide.

En ce qui concerne la forme d'exécution représentée sur les figures 3 à 6, il suffit, pour éviter toute possibilité de rupture de contact et de formation de surépaisseurs sur la face avant des plaques, de remplacer chacune des paires de pointes de contact 61 à 63 par une seule pointe 64 dont la forme est représentée sur les figures 8a et 8b.

Cette pointe 64 se présente sous la forme d'un petit cylindre de diamètre supérieur à deux fois l'épaisseur des plaques de circuits intégrés, qui est fixé au bout d'un fil métallique et qui présente une extrémité fourchue, formée par deux biseaux opposés 64a, 64b et par une entaille en V 64c faite dans l'arrête définie par les deux biseaux, l'angle d'ouverture de cette entaille en V étant égal à celui des rainures 28 et 52 des barres 25a et 25b de la traverse centrale 25 du chassis 20 (voir figure 3).

Naturellement on pourrait envisager de réaliser la pointe 64 sous une autre forme, par exemple celle d'un cylindre avec une rainure en V sur l'une de ses tranches, mais on n'obtiendrait pas un aussi bon contact électrique avec la couche conductrice sur les bords des plaques.

Les quatre pointes 64 peuvent être fixées sur la barre métallique 58, d'un même côté que celle-ci et aux mêmes endroits que les pointes 60 à 63 mais il faut alors prévoir dans les barres 25a et 25b de la traverse 25 des encoches comme celles 66, 67, 68, 69, qui sont représentées sur la figure 3 afin que les entailles en V des pointes 64 puissent se trouver exactement dans le prolongement des rainures des barres 25a et 25b lorsque les plaques sont en place. Par ailleurs, le montage de ces pointes 64 doit être tel que leur mise en contact avec la couche conductrice des plaques puisse être assurée grâce à l'élasticité des fils aux bouts desquels elles sont fixées.

A noter que l'utilisation de telles pointes 64 facilite encore la mise en place des plaques de circuits intégrés sur le dispositif. Bien entendu il faut veiller, au moment de cette mise en place, à ce que c'est bien la partie du bord des plaques qui est recouverte de la couche conductrice que l'on introduit dans la rainure de la traverse centrale.

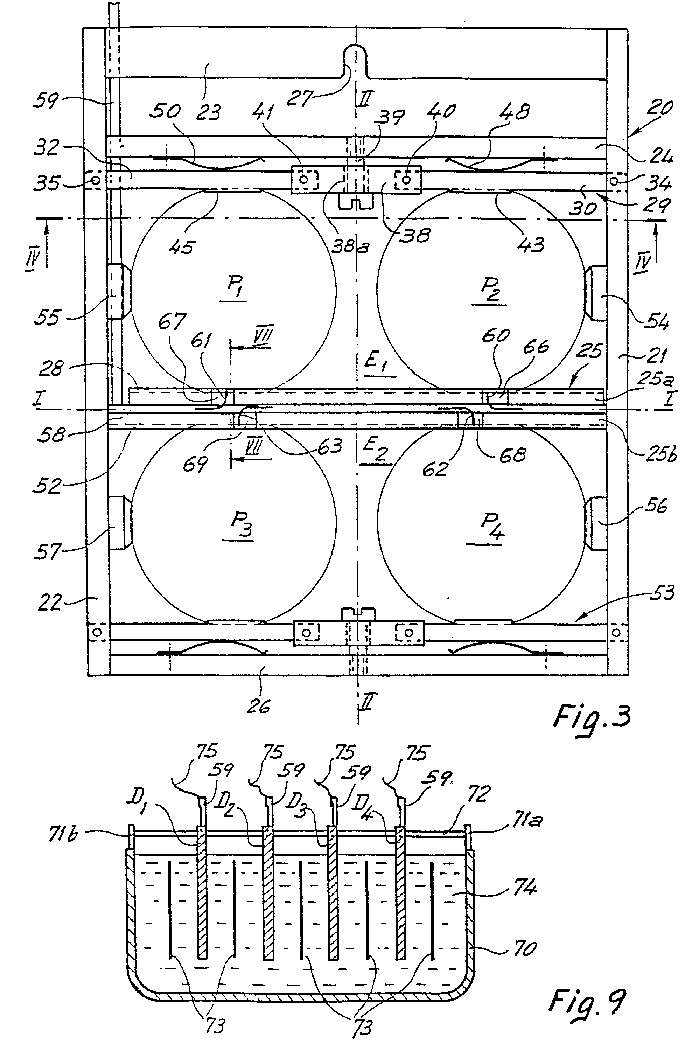

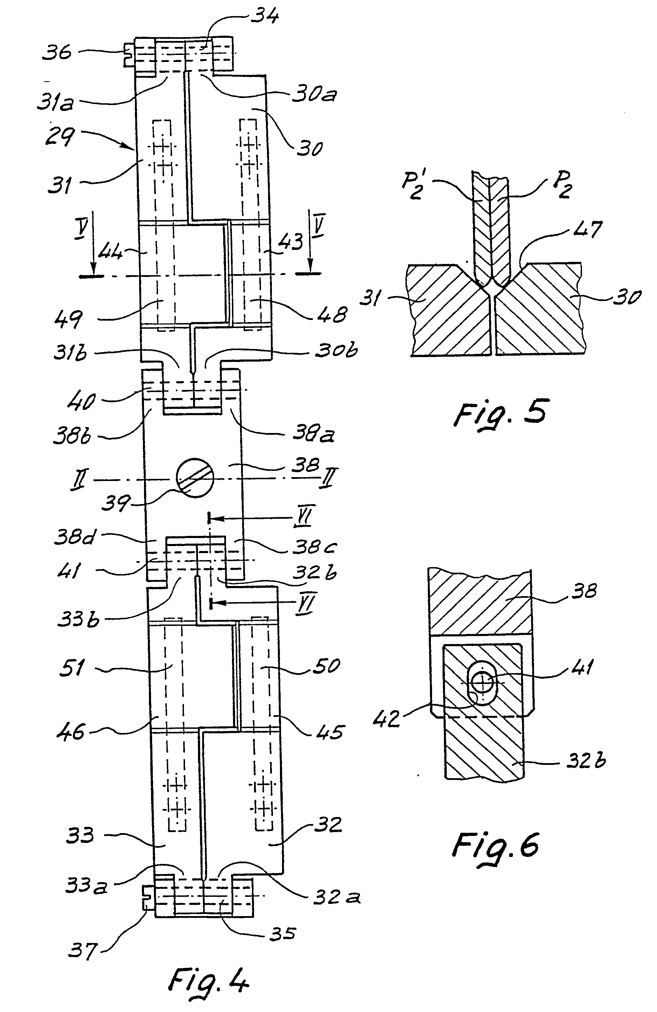

La figure 9 montre très schématiquement comment plusieurs dispositifs selon l'invention, sous la forme d'exécution qui a été chosie comme exemple, peuvent être placés dans une cuve électrolytique.

La cuve 70 porte à chacune de ses extrémités un support 71a, resp. 71b, en forme de fourche.

Les dispositifs $D_1$, $D_2$, $D_3$ et $D_4$ sont placés à peu près parallèlement en eux et en gros à égale distance l'un de l'autre, sur une barre rigide 72 qui passe dans les encoches 27 des traverses de suspension 23 et qui repose sur les supports 71a et 71b.

Lorsqu'ils sont plongés dans le bain galvanique 74 à peu près jusqu'au niveau de leur traverse supérieure 24, les dispositifs $D_1$ à $D_4$ se trouvent placés chacun entre deux anodes 73 à peu près parallèlement à celles-ci, une seule anode étant prévue entre deux dispositifs. Ces anodes qui peuvent être réalisées sous forme de plaques ou de grilles sont naturellement reliées à la borne positive de la source de tension d'alimentation de la cuve par des moyens non représentés. La figure 9 montre également des fils 75 qui partent des extrémités des tiges conductrices 59 (voir fig. 3) des dispositifs $D_1$ à $D_4$ pour connecter celles-ci à la borne négative de la source.

Naturellement l'invention n'est pas limitée à la forme d'exécution qui a été décrite.

Comme cela a déjà été indiqué, le dispositif peut être conçu pour traiter plus de quatre paires de plaques en même temps. Il peut l'être aussi pour en traiter moins, par exemple seulement deux.

Le système électrique et/ou le système de positionnement peuvent être réalisés autrement.

De plus le dispositif pourrait très bien être prévu pour être placé autrement que verticalement. Il est clair qu'il peut être adapté à différents types de cuves.

Enfin il faut préciser que le dispositif n'est pas réservé à des plaques de circuits intégrés formés sur un substrat semi-conducteur. Elle s'applique également à d'autres technologies d'intégration, mais pas forcément avec tous les mêmes avantages.

**Revendications**

1. Dispositif pour le dépôt électrolytique d'un matériau conducteur sur des plaques de circuits intégrés de forme sensiblement circulaire ayant chacune une face portant une couche électriquement conductrice sur laquelle le matériau doit être au moins localement déposé et un dos, ledit dispositif étant destiné à être placé dans une cuve électrolytique alimentée par une source de tension continue située en dehors de cette cuve, ledit dispositif comportant un châssis (20) pour recevoir au moins une première paire de plaques de circuits intégrés ($P_2$, $P'_2$) et un système électrique (58, 59, 60, 60'; 58, 59, 64, 65) solidaire du châssis pour permettre de relier ladite couche électriquement conductrice de chaque plaque à ladite source de tension, ledit dispositif comportant en outre un système mécanique (28, 29, 54) également solidaire du châssis pour positionner et maintenir en place lesdites plaques, ledit dispositif étant caractérisé en ce que les plaques sont disposées dos à dos et accolées l'une contre l'autre, sur le châssis; que le châssis comprend, disposés sensiblement dans un même plan, deux montants (21, 22) et au moins une première (24) et une seconde (25) traverse sensiblement parallèles entre elles et fixées par leurs extrémités auxdits montants de façon à être séparées par une distance supérieure au diamètre desdites plaques, lesdits montants et lesdites traverses définissant un espace ($E_1$) destiné à recevoir lesdites plaques ($P_2$, $P'_2$) dans le plan du châssis; et que ledit système mécanique comprend une rainure longitudinale (28) formée dans la seconde traverse pour recevoir une première partie (a) du bord des plaques et un mécanisme (29) disposé dans ledit espace, du côté de la première traverse et présentant, lui aussi, une rainure placée sensiblement en face de la rainure de la seconde traverse pour recevoir une deuxième partie (b) du bord des plaques diamétralement opposée à la première, ledit mécanisme étant conçu pour appliquer sur cette deuxième partie du bord une force en direction de ladite seconde traverse.

2. Dispositif selon la revendication 1, conçu plus spécialement pour des plaques de circuits intégrés dont le bord présente deux parties droites (a, b) diamétralement opposées, caractérisé par le fait que la rainure du mécanisme (29) a une longueur sensiblement égale à celle de l'une des parties droites des plaques.

3. Dispositif selon la revendication 1 ou 2, caractérisé par le fait que ledit mécanisme (29) comprend au moins un levier (30) articulé par l'une de ses extrémité (30a) sur l'un des montants (21) du châssis (20) de façon à pouvoir pivoter dans le plan de ce dernier et un ressort (48) fixé sur la première traverse (24) pour pousser ledit levier en direction de la seconde traverse (25).

4. Dispositif selon la revendication 3, caractérisé par le fait que ledit mécanisme (29) comprend deux leviers (30, 31) disposés côte à côte dans la direction perpendiculaire au plan du châssis (20) et qui sont articulés par l'une de leurs extrémités (30a, 31a) sur l'un des montants (21) du châssis (20) de façon à pouvoir pivoter dans le plan de ce dernier et autour d'un même axe (34), chaque levier étant associé à l'une desdites plaques ($P_2$, $P'_2$), ainsi que deux ressorts (48, 49) fixés sur la première traverse (24) pour pousser les deux leviers indépendamment en direction de la seconde traverse (25), et par le fait que ladite rainure du mécanisme est formée entre les deux leviers.

5. Dispositif selon l'une des revendications 1 à 4, caractérisé par le fait que les rainures du mécanisme (29) et de la seconde traverse (25) sont en forme de V, l'angle d'ouverture de ce V étant tel que la force exercée par le mécanisme sur les bords des plaques ($P_2$, $P'_2$) permette de maintenir ces dernières accolées l'une contre l'autre.

6. Dispositif selon la revendication 4 ou 5, caractérisé par le fait que l'espace ($E_1$) défini par les montants (21, 22) et les traverses (24, 25) du châssis (20) est prévu pour recevoir une seconde paire de plaques ($P_1$, $P'_1$) à côté de la première et que ledit mécanisme (29) comprend deux autres leviers (32, 33) et deux autres ressorts (50, 51) conformés et disposés de façon que ledit mécanisme soit symétrique par rapport à un plan médian (II–II), perpendiculaire au plan dans lequel les traverses sont disposées.

7. Dispositif selon la revendication 6, caractérisé par le fait que ledit mécanisme (29) comporte en outre une pièce de raccordement (38) qui est liée mécaniquement à la première traverse (24) et sur laquelle sont articulées les extrémités (30$_b$–33$_b$) des leviers (30–33) opposées à celles (30$_a$–33$_a$) qui sont solidaires des montants (21, 22) du châssis (20), de façon que, d'une part, ladite pièce de raccordement puisse être déplacée entre une première position pour laquelle les leviers sont sensiblement parallèles à la première traverse (24) et une seconde position pour laquelle elle se trouve en contact avec ladite première traverse, ce déplacement provoquant le pivotement des leviers, et que, d'autre part, deux leviers placés côte à côte puissent être soumis à un léger mouvement de cisaillement l'un par rapport à l'autre, au moins lorsque la pièce de raccordement se trouve dans sa première position.

8. Dispositif selon la revendication 6 ou 7, caractérisé par le fait que le système de positionnement et de maintien des plaques comporte en outre deux butées latérales (54, 55) pour les plaques, ces butées étant fixées chacune sur l'un des montants (21, 22) du châssis (20), sensiblement à mi-distance entre les leviers (30–33) et la seconde traverse (25).

9. Dispositif selon l'une des revendications 1 à 8, caractérisé par le fait que le châssis (20) comprend une troisième traverse (26) parallèle aux deux autres (24, 25) et qui définit avec les montants (21, 22) et la seconde traverse (25) un autre espace (E$_2$) destiné à recevoir d'autres plaques (P$_3$, P'$_3$, P$_4$, P'$_4$) et un autre système de maintien et de positionnement (52, 53, 56, 57) des plaques dans cet espace, les deux systèmes étant symétriques par rapport à un plan médian (I–I) de la seconde traverse perpendiculaire aux montants du châssis.

10. Dispositif selon l'une des revendications 1 à 9, caractérisé par le fait que le châssis (20) comporte une traverse supplémentaire (23) pour la suspension du dispositif dans la cuve.

11. Dispositif selon l'une des revendications précédentes, caractérisé par le fait que le système électrique comprend au moins une pointe de contact (60–63, 60'–63') par plaque de circuits imprimés, prévue pour venir prendre appui en un point sur la couche conductrice portée par la face de ladite plaque, au voisinage du bord de cetter dernière.

12. Dispositif selon l'une des revendications 1 à 10, conçu pour des plaques de circuits intégrés sur lesquelles la couche conductrice recouvre également au moins une partie du bord dè celles-ci, caractérisé par le fait que le système électrique comprend au moins une pointe de contact (64) par paire de plaques disposées dos à dos et que chaque pointe de contact présente à son extrémité une entaille (64$_c$) et est placée sur le châssis (20) de façon que les parties (a) des bords des plaques recouvertes par ladite couche conductrice pénètrent dans ladite entaille et soient maintenues en contact avec ladite pointe.

13. Dispositif selon la revendication 11 ou 12, caractérisé par le fait que les pointes de contact (60–63, 60'–63'; 64) sont fixées sur une même pièce (58) en matériau électriquement conducteur qui est solidaire du châssis (20).

**Claims**

1. A device for the electrolytic deposition of a conductive material on integrated circuit wafers of substantially circular form and having a front face bearing an electrically conductive layer on which the material is to be deposited at least locally and a back, said device being designed to be put into an electrolytic vat fed by a source of d. c. voltage located outside this vat, said device comprising a framework (20) for receiving at least a first pair of integrated circuit wafers (P$_2$, P'$_2$) and an electrical system (58, 59, 60, 60'; 58, 59, 64, 65) fixed to the framework to enable coupling said electrically conductive layer of each wafer to said voltage source, said device further comprising a mechanical system (28, 29, 54) likewise fixed to the framework for positioning said wafers and holding them in place, said device being characterized by the fact that the wafers are arranged back-to-back and in contact against one another on the framework; that the framework includes, essentially in a same plane, two riser members (21, 22) and at least a first (24) and a second (25) runner members essentially parallel to one another and fastened at their ends to said riser members so as to be separated by a distance greater than the diameter of said wafers, said riser and runner members defining a space (E$_1$) intended to receive said wafers (P$_2$, P'$_2$) in the plane of the framework; and that said mechanical system includes a longitudinal groove (28) formed in the second runner member for receiving a first portion (a) of the periphery of the wafers and a mechanism (29) positioned in said space, on the side of the first runner member, and likewise including a groove substantially facing the groove of the second runner member, for receiving a second portion (b) of the periphery of the wafers diametrically opposed to the first one, said mechanism being designed to apply a force directed towards said second runner member to this second portion of the periphery.

2. A device according to claim 1, designed more particularly for integrated circuit wafers the periphery of which exhibits two diametrically opposite linear portions (a, b), characterized by the fact that the groove of the mechanism (29) has a length substantially equal to that of one of the linear portions of the wafers.

3. A device according to claim 1 or 2, characterized by the fact that said mechanism (29) comprises at least one lever (30) articulated at one of its ends (30a) on one of the riser members (30) of the framework (20), so as to be pivotable in the plane of this last one and a spring (48) fixed to the first runner member (24) for urging said lever towards the second runner member (25).

4. A device according to claim 3, characterized by the fact that said mechanism (29) comprises two levers (30, 31) arranged side by side in the direction perpendicular to the plane of the framework (20) and which are each articulated at one end (30a, 31a) thereof on one of the riser members (21) of the framework (20) so as to be pivotable in the plane thereof and about a common axis (34), each lever being associated with one of said wafers ($P_2$, $P'_2$) as well as two springs (48, 49) fixed to the first runner member (24) so as to urge the two levers independently towards the second runner member (25), and by the fact that said groove of the mechanism is formed between the two levers.

5. A device according to anyone of claims 1 to 4, characterized by the fact that the grooves of the mechanism (29) and of the second runner member (25) are in the form of a V the apex angle of which is such that the force exerted by the mechanism on the periphery of the wafers ($P_2$, $P'_2$) enables to maintain these wafers in contact against one another.

6. A device according to claim 4 or 5, characterized by the fact that the space ($E_1$) defined by the riser members (21, 22) and the runner members (24, 25) of the framework (20) is designed to receive a second pair of wafers ($P_1$, $P'_1$) placed beside the first pair thereof and that said mechanism (29) comprises two further levers (32, 33) and two further springs (50, 51) adapted and arranged so that said mechanism is symmetric about a median plane (II–II) perpendicular to the plane in which the runner members are arranged.

7. A device according to claim 6, characterized by the fact that said mechanism (29) further comprises an attachment member (38) which is mechanically coupled to the first runner member (24) and on which are articulated the ends ($30_b$–$33_b$) of the levers (30–33) opposite to those ($30_a$–$33_a$) which are attached to the riser members (21, 22) of the framework (20), in a manner such that, on one hand, said attachment member may be displaced between a first position in which the levers are substantially parallel to the first runner member (24) and a second position in which the attachment member is in contact with said first runner member, this displacement effecting pivoting of the levers and that, on the other hand, two levers located side by side may be subjected to a small shearing movement relative to one another at least when the attachment member is in its first position.

8. A device according to claim 6 or 7, characterized by the fact that the system for positioning the wafers and maintaining them in place further comprises two lateral abutments (54, 55) for the wafers, these abutments each being fixed to one of the riser members (21, 22) of the framework (20), substantially midway between the levers (30–33) and the second runner member (25).

9. A device according to anyone of claims 1 to 8, characterized by the fact that the framework (20) includes a third runner member (26) parallel to the two others (24, 25) and which defines, with the riser members (21, 22) and the second runner member (25), a further space ($E_2$) intended to receive further wafers ($P_3$, $P'_3$, $P_4$, $P'_4$) and a further system (52, 53, 56, 57) for positioning these wafers and maintaining them in place in this space, the two systems being symmetrical about a median plane (I–I) of the second runner member perpendicular to the riser members of the framework.

10. A device according to anyone of claims 1 to 9, characterized by the fact that the framework (20) includes an additional runner member (23) for the suspending thereof in the vat.

11. A device according to anyone of the preceding claims, characterized by the fact that the electrical system comprises at least one contact point (60–63, 60'–63') per integrated circuit wafer provided for being brought to bear at one point on the conductive layer borne by the face of said wafer proximate the periphery thereof.

12. A device according to anyone of claims 1 to 10, intended for printed circuit wafers on which the conductive layer likewise covers at least a portion of the periphery thereof, caracterized by the fact that the electrical system comprises at least one contact point (64) per pair of back-to-back wafers and that each contact point exhibits a notch ($64_c$) at its end and is placed on the framework (20) in a manner such that the portions (a) of the peripheries of the wafers covered by said conductive layer penetrate said notch and are maintained in contact with said point.

13. A device according to claim 11 or 12, characterized by the fact that the contact points (60–63, 60'–63'; 64) are fixed to a common piece (58) of electrically conductive material which is attached to the framework (20).

**Patentansprüche**

1. Anordnung für die elektrolytische Abscheidung eines Leitermaterials auf integrierten Schaltungsscheiben kreisrunder Form, die jeweils eine Trägerseite für eine elektrisch leitende Schicht umfassen, auf der das Material zumindest teilweise aufzutragen ist, und einen Rücken, wobei die genannte Anordnung dazu bestimmt ist, in einer elektrolytischen Wanne eingesetzt zu werden, die von einer außerhalb dieser Wanne angeordneten Gleichspannungsquelle gespeist wird, die genannte Anordnung ein Gestell (20) umfaßt, um mindestens ein erstes Paar von integrierten Schaltungsscheiben ($P_2$, $P'_2$) aufzunehmen, und ein mit dem Gestell fest verbundenes elektrisches System (58, 59, 60, 60'; 58, 59, 64, 65), das die Verbindung der genannten elektrisch leitenden Schicht jeder Scheibe zur genannten Spannungsquelle gestattet, wobei die genannte Anordnung ferner ein ebenfalls fest mit dem Gestell verbundenes mechanisches System (28, 29, 54) umfaßt, um die genannten Scheiben zu positionieren und zu halten, dadurch gekennzeichnet, daß die Scheiben auf dem Gestell Rücken an Rücken aneinandergefügt sind; daß das Gestell zwei in derselben Ebene angeordnete Säulen (21, 22) umfaßt und mindestens einen ersten (24) und einen zweiten (25) Querträger, die parallel zueinander verlaufen und jeweils an einem Ende an der genannten Säule derart befestigt sind, daß ihr Abstand zueinander größer ist als der Durchmesser der genannten Scheiben, wobei die genannten Säulen und die genannten Querträger einen zur Aufnahme der genannten Scheiben ($P_2$, $P'_2$) in der Ebene des Gestells vorgesehenen Raum ($E_1$) definieren; und dadurch, daß das genannte mechanische System eine im zweiten Querträger ausgebildete Längskehle (28) umfaßt, um einen ersten Teil (a) des Scheibenrandes aufzunehmen und einen im genannten Raum auf der Seite des ersten Querträgers angeordneten Mechanismus (29), der ebenfalls eine Kehle aufweist, die gegenüber der Kehle des zweiten Querträgers angeordnet ist, um einen zweiten, dem ersten gegenüberliegenden Teil (b) des Scheibenrandes aufzunehmen, wobei der genannte Mechanismus so ausgelegt ist, daß er auf diesen zweiten Teil des Randes eine in Richtung auf den genannten zweiten Querträger wirkende Kraft ausübt.

2. Anordnung gemäß Anspruch 1, insbesondere für integrierte Schaltungsscheiben ausgelegt, deren Rand zwei gegenüberliegende gerade Teile (a, b) aufweist, dadurch gekennzeichnet, daß die Kehle des Mechanismus' (29) eine Länge hat, die gleich der eines der geraden Teile der Scheiben ist.

3. Anordnung gemäß Anspruch 1 oder 2, dadurch gekennzeichnet, daß der genannte Mechanismus (29) mindestens einen Hebel (30) umfaßt, der an einem Ende (30a) auf einer der Säulen (21) des Gestells (20) derart gelenkig gelagert ist, daß er in dessen Ebene schwenkbar ist, und eine am ersten Querträger (24) befestigte Feder (48), um den genannten Hebel in Richtung auf den zweiten Querträger (25) zu drücken.

4. Anordnung gemäß Anspruch 3, dadurch gekennzeichnet, daß der genannte Mechanismus (29) zwei nebeneinander angeordnete, rechtwinklig zur Ebene des Gestells (20) verlaufende Hebel (30, 31) umfaßt, die an einem ihrer Enden (30a, 31a) auf einer der Säulen (21) des Gestells (20) derart gelenkig gelagert sind, daß sie in dessen Ebene und um dieselbe Achse (34) schwenkbar sind, wobei jeder Hebel einer der genannten Scheiben ($P_2$, $P'_2$) zugeordnet ist, sowie zwei auf dem ersten Querträger (24) befestigte Federn (48, 49), um die beiden Hebel unabhängig voneinander in Richtung auf den zweiten Querträger (25) zu drücken, und dadurch, daß die genannte Kehle des Mechanismus' zwischen den beiden Hebeln ausgebildet ist.

5. Anordnung gemäß einem der Ansprüche 1 bis 4, dadurch gekennzeichnet, daß die Kehlen des Mechanismus (29) und des zweiten Querträgers (25) V-förmig ausgebildet sind, wobei der Öffnungswinkel dieser V-Form so ist, daß die vom Mechanismus auf die Ränder der Scheiben ($P_2$, $P'_2$) ausgeübte Kraft gestattet, die Scheiben aneinandergefügt zu halten.

6. Anordnung gemäß Anspruch 4 oder 5, dadurch gekennzeichnet, daß der durch die Säulen (21, 22) und die Querträger (24, 25) des Gestells (20) definierte Raum ($E_1$) so ausgebildet ist, daß er neben dem ersten ein zweites Paar Scheiben ($P_1$, $P'_1$) empfangen kann, und daß der genannte Mechanismus zwei weitere Hebel (32, 33) und zwei weitere Federn (50, 51) umfaßt, die so ausgebildet und angeordnet sind, daß der genannte Mechanismus symmetrisch zu einer mittleren Ebene (II–II) verläuft, rechtwinklig zu der Ebene, in der die Querträger angeordnet sind.

7. Anordnung gemäß Anspruch 6, dadurch gekennzeichnet, daß der genannte Mechanismus (29) ferner ein mechanisch mit dem ersten Querträger (24) verbundenes Anschlußstück (38) umfaßt, auf dem die Enden ($30_b$–$33_b$) der Hebel (30–33) gelenkig gelagert sind, die den fest mit den Säulen (21, 22) des Gestells (20) verbundenen Enden ($30_a$–$33_a$) gegenüberliegen, so daß einerseits das genannte Anschlußstück zwischen einer ersten Position, in der die Hebel parallel zum ersten Querträger (24) verlaufen, und einer zweiten Position, in der es am genannten ersten Querträger anliegt, verschoben werden kann, wobei diese Verschiebung das Schwenken der Hebel bewirkt, und daß andererseits zwei nebeneinander angeordnete Hebel mit einer leichten Scherbewegung zueinander beaufschlagt werden können, zumindest wenn sich das Anschlußstück in seiner ersten Position befindet.

8. Anordnung gemäß Anspruch 6 oder 7, dadurch gekennzeichnet, daß das Scheibenpositionier- und Haltesystem ferner zwei seitliche Anschläge (54, 55) für die Scheiben umfaßt, wobei diese Anschläge jeweils auf einer der Säulen (21, 22) des Gestells (20) befestigt sind, auf halbem Abstand zwischen den Hebeln (30–33) und dem zweiten Querträger (25).

9. Anordnung gemäß einem der Ansprüche 1 bis 8, dadurch gekennzeichnet, daß das Gestell (20) einen dritten Querträger (26) umfaßt, der parallel zu den beiden anderen (24, 25) verläuft und mit den Säulen (21, 22) und dem zweiten Querträger (25) einen weiteren Raum ($E_2$) definiert, der weitere Scheiben ($P_3$, $P'_3$, $P_4$, $P'_4$) aufnehmen kann, und ein weiteres Scheibenpositionier- und Haltesystem (52, 53, 56, 57) in diesem Raum, wobei die beiden Systeme symmetrisch zu einer mittleren Ebene (I–I) des ersten Querträgers verlaufen, rechtwinklig zu den Säulen des Gestells.

10. Anordnung gemäß einem der Ansprüche 1 bis 9, dadurch gekennzeichnet, daß das Gestell (20) einen zusätzlichen Querträger (23) zur Aufhängung der Anordnung in der Wanne umfaßt.

11. Anordnung gemäß einem beliebigen der vorhergehenden Ansprüche, dadurch gekennzeichnet, daß das elektrische System mindestens eine Kontaktspitze (60–63, 60'–63') pro Schaltungsscheibe umfaßt, die sich in einem Punkt in der Nähe des Scheibenrandes an die von der einen Seite der genannten Scheibe getragenen Leiterschicht andrückt.

12. Anordnung gemäß einem der Ansprüche 1 bis 10, ausgelegt für integrierte Schaltungsscheiben, auf denen die Leiterschicht auch mindestens einen Teil des Scheibenrandes bedeckt, dadurch gekennzeichnet, daß das elektrische System mindestens eine Kontaktspitze (64) pro Rücken an Rücken angeordnetem Scheibenpaar umfaßt und daß jede Kontaktspitze an ihrem Ende eine Einkerbung (64$_c$) aufweist und auf dem Gestell (20) so angeordnet ist, daß die von der Leiterschicht bedeckten Teile (a) der Scheibenränder in die genannte Einkerbung eindringen und mit der genannten Spitze in Kontakt gehalten werden.

13. Anordnung gemäß Anspruch 11 oder 12, dadurch gekennzeichnet, daß die Kontaktspitzen (60–63, 60′–63′; 64) auf einem selben, fest mit dem Gestell (20) verbundenen Teil (58) aus elektrisch leitendem Material befestigt sind.

Fig.1

Fig.7

Fig.8a

Fig.8b

Fig.2

EP 0 144 752 B1

Fig.3

Fig.9

**Fig. 4**

**Fig. 5**

**Fig.6**